# EUROPEAN PATENT APPLICATION

(11) **EP 4 825 895 A1**
(43) Date of publication of application: **21.10.2026**
(21) Application number: 24903597.3
(22) Date of filing: 05.12.2024
(51) Int. Cl.: C08G 69/32, C08J 5/18, H10N 30/20, H10N 30/30, H10N 30/045, H10N 30/85, H10N 30/857

(54) **POLYMER, AROMATIC POLYAMIDE, MOLDED OBJECT, FILM, VIBRATION SENSOR, SPEAKER, AND STRUCTURAL-HEALTH MONITORING SYSTEM**

(30) Priority: 14.12.2023 JP 2023210976; 11.07.2024 JP 2024111594
(71) Applicant: Toray Industries, Inc., Tokyo 103-8666 (JP)
(72) Inventor: HAMADA Hiroyoshi, Otsu-shi, Shiga 520-8558 (JP); TSUKUDA Akimitsu, Otsu-shi, Shiga 520-8558 (JP)
(74) Representative: Kador & Partner Part mbB
(86) International application number: PCT/JP2024/043026
(87) International publication number: WO 2025/126940

(57) **Abstract**

[Problem]

To provide a polymer, an aromatic polyamide, a molded body, and a film, which are excellent in piezoelectric properties and mechanical properties.

[Solution]

A polymer is provided in which each hydrogen-bonding group in a repeating unit is bonded to a ring atom, the number of atoms present on the shortest pathway among pathways connecting atoms between the hydrogen-bonding groups is an odd number, and the remanent polarization is 15 mC/m² or more and 300 mC/m² or less.

## Description

### TECHNICAL FIELD

The present invention relates to a polymer having ferroelectricity, an aromatic polyamide, a molded body, and a film.

### BACKGROUND ART

Ferroelectric materials are used for various sensors and image recording applications due to their piezoelectricity and pyroelectricity. Conventionally, inorganic materials represented by PbZrTiO₃ (PZT), vinylidene fluoride polymers such as polyvinylidene fluoride (PVDF), polylactic acid, and polymer materials represented by odd-numbered nylon have been known as ferroelectric materials. Among these, inorganic materials have advantages in terms of properties such as excellent pyroelectricity and heat resistance, but since they have poor flexibility and are difficult to mold, they are unsuitable as materials for large-area, thin-film, and complex-shaped piezoelectric elements. On the other hand, although polymer materials have lower piezoelectric and pyroelectric constants than inorganic materials, they have small specific heat and dielectric constants, and thus have a good figure of merit, and their use as piezoelectric elements in applications requiring flexibility, lightness, and large area such as wearable devices, and application to memory materials and the like are being studied. In the case of polymer materials, remanent polarization is formed by aligning the directions of dipoles in the polymer in one direction, and ferroelectricity is exhibited. In many cases, the orientation of dipoles is achieved by controlling the higher-order structure of the polymer chain through molecular orientation or the crystal system in the material. As this method, for example, there can be mentioned a method of performing so-called poling treatment in which an electric field is applied to the polymer for a certain period of time and the structure is fixed while maintaining the electric field after making the polymer chain movable by setting the polymer to a temperature equal to or higher than the glass transition temperature and equal to or lower than the melting point, and a method of performing mechanical uniaxial stretching or biaxial stretching. However, since ferroelectricity is deactivated because the higher-order structure collapses due to stress or heat generated in the material during use, limited durability and use environment are problems of polymer materials.

As a polymer material expected to have high durability along with ferroelectricity, an aromatic polyamide can be mentioned. Particularly, wholly aromatic polyamides have excellent heat resistance and chemical resistance and are therefore used as heat-resistant fibers and high-modulus fibers; meanwhile, since they have amide bonds with large dipole moments, they are expected to show ferroelectricity similar to odd-numbered nylon by appropriately selecting the aromatic structure. As an example of such a material, for example, Patent Document 1 discloses a polyamide film having remanent polarization. Patent Document 2 discloses a polyamide-based liquid crystal aligning agent varnish.

Patent Document 3 discloses a mixture of a ferroelectric aromatic polyamide and a liquid crystalline polymer. Patent Document 4 discloses a block copolymer of a ferroelectric aromatic polyamide and a polymer having a melting point and a glass transition temperature. Patent Document 5 discloses a production method of obtaining a piezoelectric polyamide film by uniaxially stretching a film obtained by applying and drying an aliphatic polyamide dissolved in an organic solvent on a substrate and then heat-treating and cooling it.

### PRIOR ART DOCUMENTS

### PATENT DOCUMENTS

Patent Document 1: JP H8-302036 A
Patent Document 2: JP 2002-363280 A
Patent Document 3: JP 2002-37889 A
Patent Document 4: JP 2001-279117 A
Patent Document 5: JP 2020-167203 A

### SUMMARY OF INVENTION

### PROBLEMS TO BE SOLVED BY THE INVENTION

However, the aromatic polyamides disclosed in Patent Documents 1 to 2 are not wholly aromatic polyamides, and the dielectric constant and remanent polarization may decrease due to the inclusion of an alkyl moiety in the structure. Also, the aromatic polyamide-based materials disclosed in Patent Documents 3 to 4 introduce a flexible polymer structure in order to set the glass transition temperature and/or melting point of the polymer to a temperature that is easy to handle industrially, but this may cause the content of the aromatic polyamide moiety to decrease, leading to a reduction in ferroelectricity. The manufacturing method of a piezoelectric film disclosed in Patent Document 5 is limited to aliphatic polyamides, and it is difficult to apply the described manufacturing method to wholly aromatic polyamides due to differences in polymer solubility and packing properties. Moreover, due to the above structural differences, any of the materials disclosed in Patent Documents 1 to 5 may be inferior in durability against heat and stress when compared with wholly aromatic polyamides.

The objective of the present invention is to provide a molded body and/or a film having excellent piezoelectric properties, mechanical properties, and heat resistance by providing a ferroelectric aromatic polyamide in which each amide group in the repeating unit is connected via an odd number of atoms and the amide group is bonded to a ring atom.

### MEANS FOR SOLVING THE PROBLEMS

To achieve the above objective, the present invention is characterized by the following.
(1) A polymer comprising a structure of the following Chemical Formula (I) as a repeating unit, the polymer satisfying the following (i) and (ii).
   (i): A hydrogen-bonding group A in the Chemical Formula (I) is bonded to a ring atom.
   (ii): In pathways connecting atoms between two "A"s in the Chemical Formula (I), the number of atoms present on the shortest pathway is an odd number.
      Chemical Formula (I): 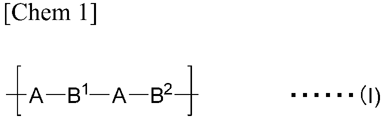 A is a hydrogen-bonding group, and B¹ and B² are n-membered ring groups (where n is a natural number of 5 or more and 10 or less).
(2) The polymer according to (1), having a remanent polarization of 15 mC/m² or more and 300 mC/ m² or less.
(3) The polymer according to (1) or (2), wherein the hydrogen-bonding group A is at least one of an amide group, a urea group, and a urethane group.
(4) An aromatic polyamide in which the hydrogen-bonding group A is an amide group and B¹ and B² are both aromatic groups.
(5) An aromatic polyamide comprising a structure of Chemical Formula (II) as a repeating unit, the aromatic polyamide satisfying the following (iii) and (iv) and having a remanent polarization of 15 mC/ m² or more.
   (iii): X in Chemical Formula (II) is bonded to an aromatic ring atom.
   (iv): In a pathway connecting atoms between two "X"s in Chemical Formula (II), the number of atoms present on the shortest pathway is an odd number.
   Chemical Formula (II): 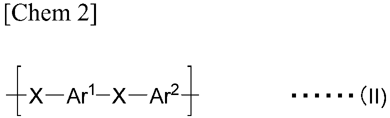
   X is an amide group, and Ar¹ and Ar² are aromatic groups.
(6) The polymer and/or aromatic polyamide according to any one of (1) to (5), wherein a structure in the repeating unit satisfies at least one of the following (v) to (viii).
   (v): An electron-donating group is bonded to an atom on the shortest pathway among pathways along bonds connecting two amide group N atoms.
   (vi): An electron-withdrawing group is bonded to an atom on the shortest pathway among pathways along bonds connecting two amide group C atoms.
   (vii): An electron-withdrawing group is bonded to an atom that is not on the shortest pathway among pathways along bonds connecting two amide group N atoms.
   (viii): An electron-donating group is bonded to an atom that is not on the shortest pathway among pathways along bonds connecting two amide group C atoms.
(7) The polymer and/or aromatic polyamide according to (1) to (6), having a molecular skeleton structure of the following Chemical Formula (III).
   Chemical Formula (III): 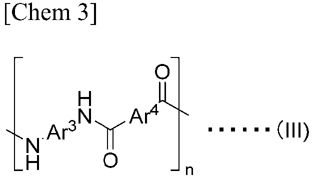
   Ar³ and Ar⁴ are groups containing a molecular skeleton structure shown in Chemical Formulas (IV) to (VIII).
   Chemical Formula (IV): 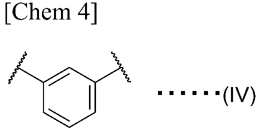
   Chemical Formula (V): 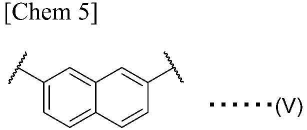
   Chemical Formula (VI): 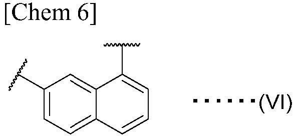
   Chemical Formula (VII): 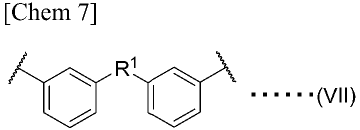
   R¹ is an arbitrary group satisfying (v) to (viii) in (6).
   Chemical Formula (VIII): 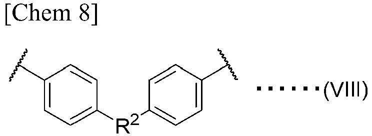
   R² is an arbitrary group satisfying (v) to (viii) in (6).
(8) The polymer and/or aromatic polyamide according to (1) to (7), having a structure of the following Chemical Formula (IX).
   Chemical Formula (IX): 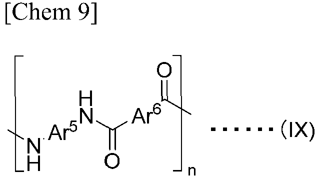
   Ar⁵ is a group containing a structure of Chemical Formulas (X) to (XII), and Ar⁶ is a group containing a structure of Chemical Formulas (XIII) to (XV).
   Chemical Formula (X): 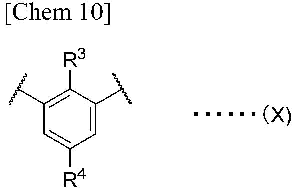
   R³ is -H or an electron-donating group, and R⁴ is an electron-withdrawing group. Chemical Formula (XI): 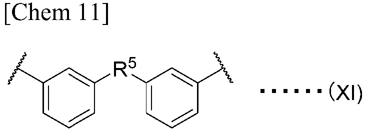
   R⁵ is an electron-donating group.
   Chemical Formula (XII): 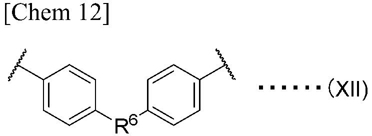
   R⁶ is an electron-withdrawing group. 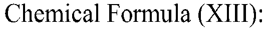 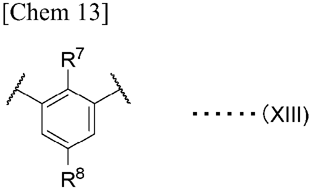
   R⁷ is an electron-withdrawing group, and R⁸ is -H or an electron-donating group. Chemical Formula (XIV): 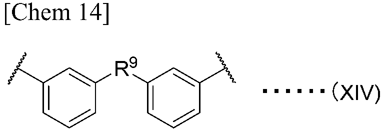
   R⁹ is an electron-withdrawing group.
   Chemical Formula (XV): 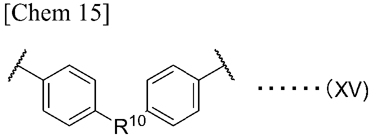
   R¹⁰ is an electron-donating group.
(9) The polymer and/or aromatic polyamide according to (1) to (8), containing at least one group of a perfluoroalkyl group having 1 or more and 3 or less carbon atoms, a nitro group, a cyano group, and a sulfone group.
(10) The polymer and/or aromatic polyamide according to (1) to (9), having a glass transition temperature of 130°C or higher and 400°C or lower.
(11) A molded body comprising the polymer and/or aromatic polyamide according to (1) to (10) as a main component.
(12) The molded body according to (11), wherein at least one of a piezoelectric constant d₃₁ or d₃₃ is greater than 0 pC/N and 50.0 pC/N or less.
(13) A film comprising the polymer and/or aromatic polyamide according to (1) to (10) as a main component.
(14) The film according to (13), having an elastic modulus obtained by AFM is 4.0 GPa or more and 15.0 GPa or less.
(15) The film according to (13), having a normalized molecular orientation MORc of 1.1 or more and 15 or less.
(16) The molded body according to (11), wherein when a dielectric constant after a heat treatment at 150°C for 10 minutes is defined as d', a larger value of absolute values | (d₃₁-d'₃₁)/d₃₁| and | (d₃₃-d'₃₃)/d₃₃ | of a change in piezoelectric constant by the heat treatment is 0 or more and 0.5 or less.
(17) A piezoelectric element comprising the molded body according to (11) and/or the film according to (13).
(18) An actuator comprising the molded body according to (11) and/or the film according to (13).
(19) A vibrator comprising the molded body according to (11) and/or the film according to (13).
(20) A vibration sensor comprising the piezoelectric element according to (17).
(21) A speaker comprising the actuator according to (18).
(22) A structural health monitoring system comprising at least the vibration sensor according to (20) and a communication device, the structural health monitoring system diagnosing a structure by detecting a vibration state of a structure by the vibration sensor.

### EFFECTS OF INVENTION

According to the present invention, a molded body and/or a film having excellent piezoelectric properties, mechanical properties, and heat resistance can be provided by the polymer and/or aromatic polyamide of the present invention. Therefore, the polymer, aromatic polyamide, molded body, and film of the present invention can be suitably used particularly as members such as piezoelectric elements, actuators, and vibrators.

### MODE FOR CARRYING OUT INVENTION

The polymer of the present invention is a polymer comprising a structure of Chemical Formula (I) as a repeating unit, and is characterized by satisfying the following (i) and (ii).
(i): A hydrogen-bonding group A in Chemical Formula (I) is bonded to a ring atom.
(ii): In a pathway connecting atoms between two "A"s in Chemical Formula (I), the number of atoms present on the shortest pathway is an odd number.

By satisfying these features, excellent mechanical properties and thermal stability derived from the hydrogen-bonding group can be combined with ferroelectricity resulting from the molecular shape and orientation. From the viewpoint of exhibiting excellent ferroelectricity, the polymer of the present invention preferably has a remanent polarization of 15 mC/m² or more and 300 mC/m² or less. Moreover, since efficient hydrogen bonding is obtained, the hydrogen-bonding group A in Chemical Formula (I) of the polymer of the present invention is preferably at least one of an amide group, a urea group, and a urethane group. The aromatic polyamide of the present invention comprises a structure of Chemical Formula (II) as a repeating unit and is characterized by satisfying the following (iii) and (iv).
(iii): X in Chemical Formula (II) is bonded to an aromatic ring atom.
(iv): In a pathway connecting atoms between two "X"s in Chemical Formula (II), the number of atoms present on the shortest pathway is an odd number.
   Chemical Formula (II):

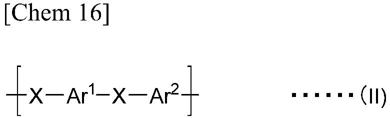

X is an amide group, and Ar¹ and Ar² are aromatic groups.

By satisfying these features, excellent mechanical properties and thermal stability derived from the aromatic polyamide can be combined with ferroelectricity resulting from the molecular shape and orientation.

Here, the aromatic ring atom is a constituent atom forming a ring structure in a cyclic molecular structure having aromaticity. Further, the pathway connecting atoms between two "X"s in Chemical Formula (II) is a pathway connecting atoms, which exist from an atom to which one X is bonded to an atom to which the other X is bonded in two adjacent "X"s, along a bond. The shortest pathway is a pathway in which the number of atoms existing on the pathway connecting atoms between two "X"s is the minimum. For example, cases where X is bonded to the 1st and 3rd positions of a benzene ring (number of atoms on the shortest pathway is 3) or where X is bonded to the 2nd and 7th positions of a naphthalene ring (number of atoms on the shortest pathway is 5) as Ar¹ and Ar² in Chemical Formula (II) satisfy both (iii) and (iv) above; however, the case where X is bonded to the 1st and 4th positions of a benzene ring (number of atoms on the shortest pathway is 4) does not satisfy (iv).

For the polymer and/or aromatic polyamide of the present invention, the lower limit of the remanent polarization is preferably 15 mC/m² or more. The lower limit of the remanent polarization is more preferably 20 mC/m² or more, and even more preferably 25 mC/m². When the lower limit of the remanent polarization is less than 15 mC/m², piezoelectricity may not be obtained when formed into a molded body or a film because of low ferroelectricity. Also, the upper limit of the remanent polarization is preferably 300 mC/m² or less, and more preferably 50 mC/m². As for the range of the remanent polarization, 15 mC/m² or more and 300 mC/m² or less is preferable, 20 mC/m² or more and 300 mC/m² or less is more preferable, 25 mC/m² or more and 300 mC/m² or less is even more preferable, and 25 mC/m² or more and 50 mC/m² or less is most preferable. To set the remanent polarization within the above range, it is important that the aromatic polyamide includes the above-mentioned structure, or that the packing or anisotropy of the aromatic polyamide is improved by performing treatment such as stretching or poling. The aromatic polyamide of the present invention preferably satisfies at least one of the following (v) to (viii) for the structure in the repeating unit shown in Chemical Formula (II).
(v): An electron-donating group is bonded to an atom on the shortest pathway among pathways along a bond connecting two amide group N atoms. (vi): An electron-withdrawing group is bonded to an atom on the shortest pathway among pathways along a bond connecting two amide group C atoms.
(vii): An electron-withdrawing group is bonded to an atom that is not on the shortest pathway among pathways along a bond connecting two amide group N atoms.
(viii): An electron-donating group is bonded to an atom that is not on the shortest pathway among pathways along a bond connecting two amide group C atoms.

Here, the electron-withdrawing group and the electron-donating group are determined by Hammett substituent constants (Chem. Rev. 1991, 91, 99-257, etc.), and a functional group having a positive σₚ value is an electron-withdrawing group, and a functional group having a negative σₚ value is an electron-donating group. In the present invention, the electron-withdrawing group is preferably a group containing at least one of a perfluoroalkyl group having 1 or more and 3 or less carbon atoms, a sulfone group, a nitro group, and a cyano group, and the electron-donating group is preferably a group containing at least one of an alkyl group having 1 or more and 3 or less carbon atoms, an alkoxy group having 1 or more and 3 or less carbon atoms, and a hydroxy group, but are not limited to these structures. By satisfying at least one of the above (v) to (viii), a dipole moment is induced, the remanent polarization increases, and the piezoelectric properties can be improved.

A meta-bonded wholly aromatic polyamide is listed as an aromatic polyamide satisfying these features, and having a structure of Chemical Formula (III) is particularly preferable from the viewpoint of polymerizability and raw material availability.

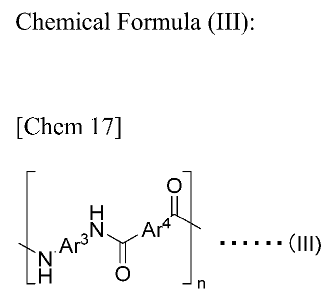

Ar³ and Ar⁴ are groups including a molecular skeleton structure shown in Chemical Formulas (IV) to (VIII), and an arbitrary group satisfying any of the above (v) to (viii) may be bonded on each molecular skeleton structure. 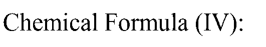 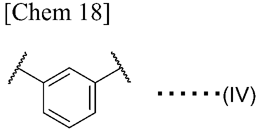 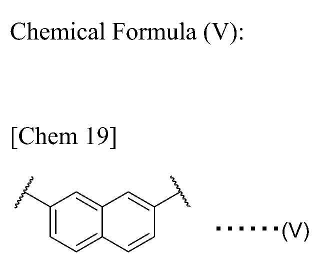 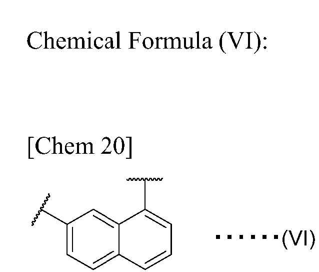 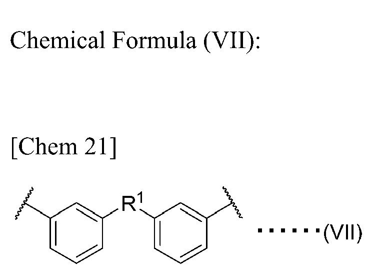 R¹ is an arbitrary group satisfying (v) to (viii) above.

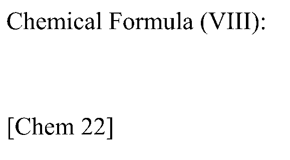

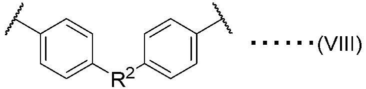

R² is an arbitrary group satisfying (v) to (viii) above.

Further, among the above, containing a structural unit of Chemical Formula (IX) is particularly preferable from the viewpoint of realizing high rigidity.

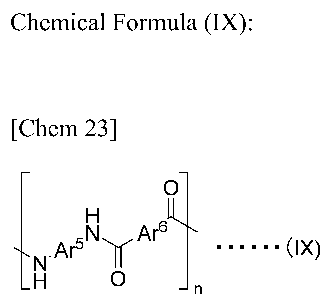

Ar⁵ is a group including a structure shown in Chemical Formulas (X) to (XII), and
Ar⁶ is a group including a structure shown in Chemical Formulas (XIII) to (XV).

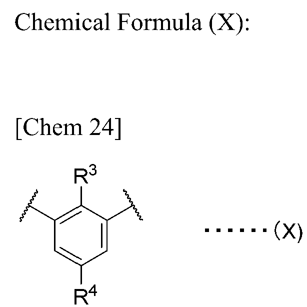

R³ is -H or an electron-donating group, and R⁴ is an electron-withdrawing group.

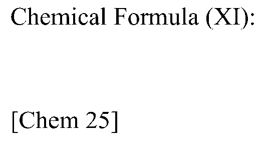

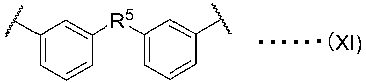

R⁵ is an electron-donating group.

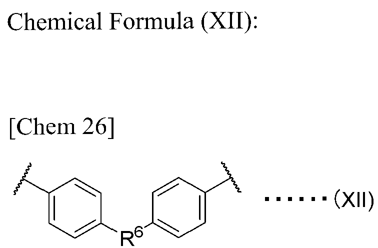

R⁶ is an electron-withdrawing group.

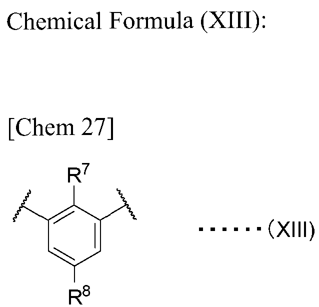

R⁷ is an electron-withdrawing group, and R⁸ is -H or an electron-withdrawing group.

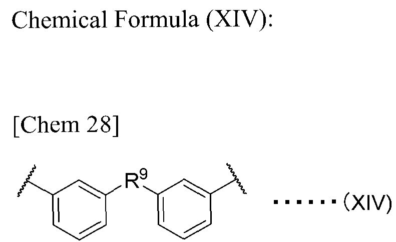

R⁹ is an electron-withdrawing group.

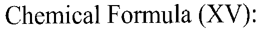

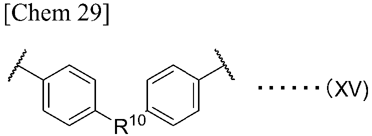

R¹⁰ is an electron-donating group.

For the aromatic polyamide of the present invention, it is preferable that the number of repeating units including the above-mentioned structure is 80% or more and 100% or less relative to the number of all repeating units in the polymer. When the proportion of repeating units including the above-mentioned structure is less than 80%, the orientation of polymer chains or dipole moments may deteriorate, leading to a decrease in ferroelectricity.

For the polymer and/or aromatic polyamide of the present invention, the lower limit of the glass transition temperature is preferably 130°C or higher, and more preferably 200°C or higher. Further, the range is preferably 130°C or higher and 400°C or lower, and more preferably 200°C or higher and 400°C or lower. Since the glass transition temperature is 130°C or higher and 400°C or lower, a reduction in ferroelectricity due to heat or passage of time can be prevented. To set the glass transition temperature to 130°C or higher and 400°C or lower, there may be mentioned that the aromatic polyamide includes the above-mentioned structure or that the content of components having a low glass transition temperature is reduced.

As an aspect of the present invention, a molded body and/or a film containing the polymer and/or aromatic polyamide of the present invention as a main component can be mentioned. Here, the phrase "containing a polymer and/or aromatic polyamide as a main component" means that a component contained in the largest amount in the molded body and/or the film is the polymer and/or aromatic polyamide described in the present invention. The amount of the component is not particularly limited, but the lower limit is preferably 70% by weight or more, and more preferably 80% by weight or more relative to the whole film. As for the range of the amount of the component, it is preferably 70% by weight or more and 100% by weight or less, and more preferably 80% by weight or more and 100% by weight or less relative to the whole film, which allows the mechanical properties derived from the aromatic polyamide to be more effectively exhibited.

The molded body and/or the film of the present invention may contain a ferroelectric material. When the molded body and/or the film of the present invention contains a ferroelectric material, the ferroelectricity is improved and excellent piezoelectric performance may be obtained. Here, the ferroelectric material may be either an organic material or an inorganic material; for example, organic ferroelectric materials include polyvinylidene fluoride (PVDF), copolymers of vinylidene fluoride and trifluoroethylene, nylon, and the like, and inorganic ferroelectric materials include lead zirconate titanate (PZT), barium titanate (BTO), lead titanate (PTO), bismuth sodium titanate-barium titanate (BNT-BT), and the like. As for the contained ferroelectric material, a material having a larger remanent polarization than the polymer and/or aromatic polyamide of the present invention when poling treatment is performed under the same conditions is preferable.

Further, for the film of the present invention, the film thickness is preferably 1 µm or more and 200 µm or less. When the film thickness is less than 1 µm, handling properties may deteriorate. When the film thickness is greater than 200 µm, flexibility decreases and processability as a film may be reduced.

For the molded body of the present invention, the lower limit of at least one of the piezoelectric constant d₃₁ or d₃₃ is preferably greater than 0 pC/N, and more preferably 5 pC/N or more. Also, the upper limit is preferably 50 pC/N or less, and more preferably 40 pC/N. As for the range, it is preferably greater than 0 pC/N and 50.0 pC/N or less, and more preferably greater than 0 pC/N and 40.0 pC/N or less. In the present invention, the method of measuring the piezoelectric constants d₃₁ and d₃₃ is not particularly limited as long as it is a method by which a sufficiently accurate value can be obtained, and it can be measured and determined by an arbitrary method. For example, aluminum electrodes are vapor-deposited on the upper and lower surfaces of a measurement sample so that an overlapping part with an area of 6 x 10⁻⁵ m² in plan view is produced. Two leads made of aluminum foil reinforced by attaching insulating adhesive tape are adhered to each of the upper and lower planar electrodes using a conductive epoxy resin. Using a dynamic viscoelasticity measuring device, a piezoelectric signal appearing when a displacement is applied to both ends of the sample at a constant frequency and amplitude can be measured with a logger via a charge amplifier, and the generated charge amount per unit area can be calculated. To set the piezoelectric constant of the molded body of the present invention within the above range, it is preferable to increase the remanent polarization of the molded body by performing poling treatment or orientation treatment by stretching.

For the film of the present invention, the lower limit of the elastic modulus obtained by atomic force microscopy (AFM) is preferably 4.0 GPa or more, and more preferably 5.0 GPa or more. Also, the upper limit is preferably 15.0 GPa or less, and more preferably 7.0 GPa or less. As for the range of the elastic modulus, it is preferably 4.0 GPa or more and 15.0 GPa or less. It is more preferably 5.0 GPa or more and 15.0 GPa or less, and even more preferably 5.0 GPa or more and 15.0 GPa or less. When the elastic modulus is less than 4.0 GPa, tearing or breakage easily occurs when used as a molded body or a film. When the elastic modulus is greater than 15.0 GPa, deformation becomes difficult and piezoelectric properties may not be obtained. By setting the elastic modulus of the film within the above range, piezoelectricity with excellent responsiveness to strain and/or electric field changes is obtained, the responsiveness of a sensor improves, and the vibration frequency of a vibrator can be broadened.

Here, the elastic modulus obtained by AFM is measured by performing force curve mapping measurement with an AFM. AFM is a scanning probe microscope that obtains information about the surface of a sample using the interatomic force between the sample and a probe (stylus), and it measures the force acting on the probe (amount of deflection of a cantilever) while changing the distance between the sample and the probe provided on the cantilever, to obtain a force curve. This force curve includes various types of information on the sample surface, and various physicochemical properties of the sample surface can be evaluated by analyzing the force curve. Force curve mapping measurement is performed at multiple points on the sample surface by scanning the acquisition of this force curve parallel to the sample surface, and it is sufficient to fix the sample to a sample fixing stand of the AFM and measure the topographical image of the sample in PeakForce QNM mode (a mode in which force curves are continuously and automatically measured at multiple points). Based on the result of the force curve mapping measurement, the elastic modulus of the sample can be evaluated by having an existing software or the like analyze the elastic modulus.

For the film of the present invention, the normalized molecular orientation MORc is preferably 1.1 or more as a lower limit, more preferably 1.2 or more, and even more preferably 1.3 or more. Also, as an upper limit, it is preferably 15 or less, and more preferably 2 or less. It is preferable that MORc is included in a range of 1.1 or more and 15 or less. More preferably, MORc is 1.2 or more and 15 or less, and even more preferably, MORc is 1.3 or more and 15 or less. Here, the normalized molecular orientation MORc is a value determined based on the molecular orientation degree MOR, which is an index showing the degree of orientation of polymer chains in a film. The molecular orientation degree MOR is measured by a microwave measurement method as follows.

That is, the molecular orientation degree MOR can be obtained by rotating a polymer piezoelectric film from 0 to 360° in a plane perpendicular to the traveling direction of microwaves in a microwave resonance waveguide of a well-known microwave transmission type molecular orientation system, and measuring the microwave intensity transmitted through the sample. The normalized molecular orientation MORc is the molecular orientation degree MOR when a reference thickness tc is 50 µm, and can be determined by the following formula.$MORc = \left(tc/t\right) \times \left(MOR-1\right) + 1$ Here, tc is the reference thickness, and t is the film thickness. The normalized molecular orientation MORc can be measured with a known molecular orientation meter, for example, MOR-7015 manufactured by Oji Scientific Instruments Co., Ltd. When the film is a stretched film, the normalized molecular orientation MORc can be controlled by stretching conditions such as the stretching ratio and stretching temperature of the film, and film forming conditions such as temperature and speed. By setting the normalized molecular orientation MORc within the above range, the orientation and/or packing properties of molecular chains in the film are improved, and excellent piezoelectricity can be obtained. In order to set MORc within the above range, it is preferable that the main component of the molded body and/or the film is the polymer and/or aromatic polyamide described in the present invention, or to perform uniaxial stretching. In the molded body and/or the film of the present invention, when the piezoelectric constant after performing heat treatment at 150°C for 10 minutes is defined as d', the larger value of the absolute value | (d₃₁ - d'₃₁)/d₃₁ | and | (d₃₃ - d'₃₃)/d₃₃ | of the change rate of the piezoelectric constant due to the heat treatment is preferably 0 or more and 0.5 or less, more preferably 0 or more and 0.3 or less, and even more preferably 0 or more and 0.2 or less. By setting the change rate of the piezoelectric constant due to the heat treatment within the above range, the piezoelectric properties are less likely to depend on temperature conditions, and the performance of sensors and actuators during use under high temperature conditions or for a long time can be stabilized. In order to set the change rate of the piezoelectric constant due to the heat treatment within the above range, it is preferable that the main component of the molded body and/or the film is the polymer and/or aromatic polyamide described in the present invention. Here, the piezoelectric constants d'₃₁ and d'₃₃ after performing heat treatment at 150°C for 10 minutes can be measured by the same method as the above d₃₁ and d₃₃, except for using the heat-treated molded body and/or film as a sample. The heat treatment of the molded body and/or the film is preferably performed by leaving the molded body and/or the film in a hot air oven set at 150°C for 10 minutes. The molded body and/or the film of the present invention may contain organic-inorganic hybrid resins such as thermosetting resins, ultraviolet curable resins, hydrolysis/condensation resins, and alkoxysilane compounds for the purpose of adjusting mechanical properties, density, and the like. Moreover, particles may be contained. Here, the particles may be either inorganic particles or organic particles; the inorganic particles are not particularly limited, but examples thereof include oxides, silicides, nitrides, borides, chlorides, and carbonates of metals or metalloids, and specifically, silica (SiO₂), aluminum oxide (Al2O3), zinc oxide (ZnO), zirconium oxide (ZrO₂), titanium oxide (TiO₂), antimony oxide (Sb₂O₃), and indium tin oxide (ITO). Also, for the purpose of increasing ferroelectric properties, lead zirconate titanate (PZT), barium titanate (BTO), lead titanate (PTO), bismuth sodium titanate-barium titanate (BNT-BT), or the like may be contained.

For the polymer, aromatic polyamide, molded body, film, and other contained materials of the present invention, if identification of the chemical structure, contained functional groups, and composition ratio is required, analysis can be performed by combining nuclear magnetic resonance (NMR), Fourier transform infrared spectroscopy (FT-IR), mass spectrometry (MS), elemental analysis, single crystal structure analysis, and the like for each component separated by combining techniques such as chromatography, distillation, liquid-liquid separation, and reprecipitation.

Hereinafter, the production method of the polymer, aromatic polyamide, molded body, and solution of the present invention will be described, but the present invention is not limited thereto.

As a method of obtaining the polymer and/or aromatic polyamide, various known methods such as a solution polymerization method and a precipitation polymerization method can be used. For example, when an aromatic polyamide is polymerized by solution polymerization, it can be polymerized by reacting an acid dichloride and a diamine as raw materials in an aprotic solvent at a low temperature. Here, the aprotic solvent is a polar solvent having no proton (hydrogen ion) donating property, and examples thereof include N-methyl-2-pyrrolidone, N,N-dimethylacetamide, N,N-dimethylisobutylamide, 3-methoxy-N,N-dimethylpropanamide, tetrahydrofuran, γ-butyrolactone, ethyl acetate, acetonitrile, dimethylformamide, and dimethyl sulfoxide. In order to suppress the deactivation of the acid dichloride, the water content of the solvent used for polymerization is preferably more than 0 ppm and 500 ppm or less (mass basis, the same applies hereinafter), and more preferably more than 0 ppm and 200 ppm or less. Here, if the molar ratio of the acid dichloride to the diamine is equal, an ultra-high molecular weight polymer tends to be produced; therefore, it is preferable to adjust the molar ratio so that one is 96.0 to 99.8%, more preferably 96.0 to 99.0%, of the other. When polymerization is performed at this molar ratio, the terminal functional group becomes an amino group because the amount of diamine is excessive relative to the acid dichloride. In addition, although the polymerization reaction of the aromatic polyamide is accompanied by heat generation, the temperature of the solution during polymerization is preferably 40°C or lower. If it exceeds 40°C, side reactions may occur and the degree of polymerization may not sufficiently increase. The temperature of the solution during polymerization is more preferably 30°C or lower.

Here, when acid dichloride and diamine are used as raw materials, hydrogen chloride is produced as a byproduct as the reaction proceeds; therefore, the obtained aromatic polyamide solution becomes a strongly acidic solution. This solution is highly corrosive, and as it is, members such as metal substrates used in the production process of molded bodies and films may be corroded and may not be usable. As a method of removing the byproduct hydrogen chloride, a method of neutralizing and removing hydrogen chloride by adding a neutralizing agent during polymerization, a method of isolating the polymer by precipitating it, and the like can be mentioned. When hydrogen chloride is neutralized and removed during polymerization, for example, a method of neutralizing with an inorganic neutralizing agent such as lithium carbonate, calcium carbonate, or calcium hydroxide can be mentioned. In the case of neutralizing with an inorganic neutralizing agent, the solution contains an inorganic salt (for example, lithium chloride or the like) produced by the neutralization reaction. Since this inorganic salt ionizes in the solvent and coordinates to the amide group of the aromatic polyamide, it acts as a dissolution aid into the solvent; therefore, it is effective for improving the pot life of the solution and suppressing the aggregation of the polymer during molding. However, since a washing process for removing the inorganic salt is required during the molding process, it may not be usable depending on the dimensions of the molded body and/or the film and the production process.

Also, in the case of isolating the polymer by precipitating it, the polymer and hydrogen chloride can be separated by mixing the polymer solution obtained by solution polymerization with a large amount of a poor solvent such as water to precipitate the polymer as a solid, and separating it from the solution by filtration or the like. By redissolving the isolated polymer in the above-mentioned aprotic solvent, a solution can be obtained. By precipitating the polymer and separating it from hydrogen chloride, it is possible to reduce the amount of impurities remaining in the molded body and the film, without containing neutralization products generated by the reaction between the neutralizing agent and hydrogen chloride.

As a method of introducing an electron-withdrawing group and/or an electron-donating group into the aromatic polyamide of the present invention so as to satisfy at least one of the above (v) to (viii), there can be mentioned a method of polymerizing an aromatic polyamide using a monomer substituted with an electron-withdrawing group and/or an electron-donating group at a target position in advance as a raw material, a method of introducing by functionalization after polymerizing an aromatic polyamide as a raw material, and the like. In the case of introduction by functionalization of an aromatic polyamide, a method of derivatizing to a target functional group starting from a leaving group such as -H or a halogen group introduced on the aromatic ring can be mentioned. However, depending on the functional group conversion reaction used, regioselectivity may be poor, resulting in an unintended structure, or reactivity may be insufficient, leading to a low introduction rate of the functional group. For this reason, a method using a monomer substituted with an electron-withdrawing group and/or an electron-donating group in advance as a raw material is preferable.

The molded body and/or the film of the present invention is preferably obtained by filling a mold with a solution containing the polymer and/or aromatic polyamide of the present invention or casting it onto a substrate, and then curing it. Here, the material and shape of the mold or substrate, and the filling and/or casting method are not limited, and an arbitrary material and method can be used depending on the purpose and application of the molded body and/or the film.

The film of the present invention can be obtained by dissolving the polymer obtained as described above in a solvent and applying it onto a base material to form a film. Here, the solvent is not limited as long as it dissolves the polymer, but an aprotic solvent is preferable. Moreover, this solution may contain the above-mentioned resin, electrolyte, particles, and the like for the purpose of improving the properties of the film. As the film forming method, for example, a dry-wet method in which heat treatment is performed through a pre-drying process and a washing process in a wet bath, a dry method in which solvent drying is performed without a washing process, or a wet method in which heat treatment is performed after introduction into a wet bath without a solvent drying process can be mentioned. Among these, film formation may be performed by any of the methods, but from the viewpoints of simplicity of the process and workability for forming a film on an object in the production process of a device, it is preferable to form a film by the dry method.

As the method of application onto the base material, it can be selected from known methods such as a nozzle or die coating method, a roller coating method, a wire bar coating method, and a gravure coating method. The base material may be any material as long as it is not corroded by the raw material solution and does not show deformation or denaturation by heating for solvent drying, and examples thereof include a glass plate, thin-film glass, a resin film, a metal plate, a quartz plate, and a silicon wafer. In addition, the surface structure of the substrate may be smooth or may have a fine structure. As the method of solvent drying, hot air, infrared irradiation, microwave irradiation, and the like can be mentioned, and it is not particularly limited. The drying temperature is preferably 50 to 400°C. From the viewpoint of improving thermal dimensional stability and the like, it is more preferable to include a process in a temperature range of 150 to 400°C in the drying process. For the purpose of preventing surface roughness due to rapid solvent evaporation, it is even more preferable to perform solvent drying stepwise at 200 to 400°C after pre-drying at 50 to 200°C.

As a method of imparting remanent polarization to the polymer, aromatic polyamide, molded body, and film of the present invention, stretching or poling treatment may be performed during molding. When performing stretching, it is preferable to stretch the film after the above-mentioned drying process by a stretching machine. In addition, when performing poling treatment, it can be carried out by applying a voltage to the obtained film and/or molded body. As the method of applying the voltage, known methods such as a DC voltage application treatment, an AC voltage application treatment, and a corona discharge treatment can be mentioned, and an appropriate one can be selected according to the shape of the film or molded body. The applied electric field is preferably in a range of 10 kV/mm or more and 150 kV/mm or less. As the electrode, needle electrodes, wire electrodes, mesh electrodes, and flat plate electrodes are mentioned as conventionally used ones, but the present invention is not limited thereto. Further, a magnetic field may be used for the poling treatment.

The polymer, aromatic polyamide, molded body, and film of the present invention can be suitably used as a piezoelectric element, a sensor, an actuator, a diaphragm, a vibrator, raw materials thereof, and the like. A piezoelectric element, an actuator, and a vibrator comprising the molded body and/or the film of the present invention are characterized by having a conductive thin film on at least one surface of the molded body and/or the film of the present invention. Thereby, excellent responsiveness and heat resistance can be exhibited while maintaining simplicity equivalent to a piezoelectric element, an actuator, and a vibrator containing a conventional polymer piezoelectric material. The piezoelectric element, actuator, and vibrator of the present invention can be suitably used as a member mounted on a vibration sensor, a speaker, or the like. The structural monitoring system of the present invention is a system characterized by comprising at least the vibration sensor described in the present invention and a communication device, and diagnosing the vibration state of a structure by the vibration sensor. Since the structural monitoring system of the present invention comprises the vibration sensor of the present invention, durability is improved and maintenance frequency can be reduced. Here, the structural health monitoring system is a system that diagnoses how much durability a structural body has, detects aging degradation, or calculates the repair timing of the structural body by measuring the vibration state of the target structure against external factors such as earthquakes and vibrations generated by a drive unit such as a motor.

### EXAMPLES

Hereinafter, the present invention will be described more specifically with reference to examples.

Each physical property value in the present invention was evaluated in the form of a film as an example. A sample film used for each physical property evaluation was produced using the aromatic polyamide of the present invention according to the following method.

First, a sample solution was cast into a film shape on a glass plate provided with an Al electrode using an applicator. At this time, the temperatures of the sample solution, the glass plate, and the casting atmosphere were set to room temperature. The cast thickness was adjusted so that the film thickness after solvent drying would be 10 µm. Next, the glass plate was put into a hot air oven and dried at Tb - 50°C for 10 minutes, where Tb is the boiling point of the aprotic solvent constituting the solution (in the case of a mixed solvent, the boiling point of a solvent having the highest boiling point among solvents contained in an amount of 30% by mass or more relative to the total solvent amount).

Next, an aluminum electrode layer (100 nm) was attached to the surface of the obtained dry film by vapor deposition, and poling treatment was performed by increasing the temperature to Tb + 40°C at a rate of 5°C/min while an electric field of 100 kV/mm was applied using a DC high-voltage stabilized power supply EV10-1AVR+ (manufactured by Kasuga Denki Co., Ltd.) to which a wire electrode was connected. After maintaining the temperature for 15 minutes, the voltage was kept applied and the film was gradually cooled to room temperature, thereby performing a poling treatment.

In addition, the measurement method of physical properties and the evaluation method of effects in the present invention were performed according to the following methods.

### (1) Remanent polarization

An aluminum electrode (planar electrode) was vacuum-deposited on a 5 mm × 5 mm central portion of a sample film cut into 20 mm × 20 mm. To this planar electrode, electrodes of two leads (3 mm × 80 mm) made of aluminum foil reinforced by attaching insulating tape were adhered to the planar electrode with conductive double-sided tape. This sample film, a function generator, a high-voltage amplifier, and an oscilloscope were incorporated into a Sawyer-Tower circuit, and a triangular wave was applied to the sample film (maximum ± 10 kV). By measuring the response of the sample film using an oscilloscope, the amount of remanent polarization at an applied electric field of 100 kV/mm was determined.

### (2) Glass transition temperature

For a sample film, it was determined from the inflection point of the storage modulus (E') by dynamic viscoelasticity measurement (DMA) in accordance with ASTM E1640-13. DMA was performed with the following device and conditions.

### Device: Viscoelasticity measuring device DMS6100 (manufactured by Seiko Instruments Inc.)

Measurement mode: Tensile mode
Measurement frequency: 1 Hz
Temperature increase rate: 5°C/min
Temperature range: 25°C to 400°C
Holding time: 2 minutes.

### (3) Piezoelectric constant

Using a piezometer YE2730 of SINOCERA PIEZOTRONICS or an equivalent product thereof, d₃₁ and d₃₃ were measured at 10 points selected on the sample by applying a force of 0.25 N and 110 Hz. The arithmetic mean values of the measured d₃₁ and d₃₃ were compared, and the larger mean value was taken as the value of the piezoelectric constant of the sample. Note that the measured values of d₃₁ and d₃₃ become a positive value or a negative value depending on the front and back or orientation of the measured sample, but in this specification, the absolute value is treated as the measured value.

### (4) Change rate of piezoelectric constant due to heat treatment

The sample was left to stand for 10 minutes. After taking it out from the hot air oven and air-cooling it to room temperature, d'₃₁ and d'₃₃ were measured in the same manner as the method described in (3) Piezoelectric constant. Using the obtained d₃₁, d₃₃, d'₃₁, and d'₃₃, | (d₃₁ - d'₃₁)/d₃₁| and | (d₃₃ - d'₃₃)/d₃₃ | were calculated, and the larger value among these was taken as the change rate of the piezoelectric constant due to the heat treatment of the sample.

### (5) Elastic modulus

Measurement was carried out in PeakForce QNM mode using an AFM (Dimension Icon manufactured by Bruker Corporation), and from the obtained force curve, analysis based on the JKR contact theory was performed using the attached analysis software NanoScope Analysis V1.40 to determine the elastic modulus distribution.

Specifically, according to the manual of PeakForce QNM mode, after performing calibration of the warp sensitivity of the cantilever, the spring constant, and the tip curvature, measurement was carried out under the following conditions, and the data of the obtained DMT Modulus channel was adopted as one data of the elastic modulus. The spring constant and the tip curvature vary depending on individual cantilevers, but a cantilever satisfying conditions of a spring constant of 0.3 N/m or more and 0.5 N/m or less and a tip curvature radius of 15 nm or less was adopted as a range not affecting the measurement and used for the measurement. The above measurement was carried out for 5 samples arbitrarily collected, and the number average of the obtained data was taken as the elastic modulus of the sample film.

Measurement conditions are shown below.
Measurement device: Atomic force microscope (AFM) manufactured by Bruker Corporation
Measurement mode: PeakForce QNM (force curve method)
Cantilever: SCANASYST-AIR manufactured by Bruker AXS
(Material: Si, spring constant K: 0.4 N/m, tip curvature radius R: 2 nm)
Measurement atmosphere: 23°C, in the atmosphere
Measurement range: 3 µm square
Resolution: 512 × 512
Cantilever movement speed: 10 µm/s
Maximum indentation load: 10 nN.

### (6) Normalized molecular orientation

For a sample piece cut out from a sample film at 10 cm × 10 cm, the normalized molecular orientation MORc was measured under the following measurement conditions.
Measurement device: MOR-7015 manufactured by Oji Scientific Instruments Co., Ltd.
Frequency: 15 GHz
Reference thickness tc: 50 mm.

### (Example 1)

In dehydrated DMAc (boiling point 165°C), 5-nitro-m-phenylenediamine corresponding to 100 mol% relative to the total amount of diamine was dissolved as a diamine under a nitrogen gas stream, and the liquid temperature was cooled to 5°C in an ice water bath. Thereinto, while maintaining the inside of the system in the ice water bath under a nitrogen gas stream, 2-nitroisophthalic acid dichloride corresponding to 99 mol% relative to the total amount of diamine was added over 30 minutes, and after the total amount was added, stirring was performed for about 1 hour to polymerize an aromatic polyamide (Polymer A). The obtained polymerization solution was added to a large amount of pure water while stirring to solidify Polymer A into a fiber shape, which was then pulverized with a mixer for 5 minutes and dried in a hot air oven at 80°C for 1 hour and in a vacuum oven at 120°C for 12 hours to obtain a powder of Polymer A. A solution was obtained by dissolving Polymer A in DMAc so that the polymer concentration was 10% by mass. The solution of Polymer A was applied in a film shape onto a glass plate provided with an Al electrode, and after being dried in a hot air oven at 130°C for 10 minutes, poling treatment was performed under the above-mentioned conditions to obtain a film made of Polymer A having a thickness of 10 µm. Here, as the hot air oven, a safety oven SPH100 (manufactured by ESPEC CORP.) was used, and it was used 1 hour after the temperature display reached the set temperature with the opening/closing damper at 50%. The evaluation results of the obtained sample are shown in Table 1. Note that Polymer A has a structure of Chemical Formula (VIV) in which Ar⁵ is Chemical Formula (X) and Ar⁶ is Chemical Formula (XIII).

### (Example 2)

An aromatic polyamide (Polymer B) and a film thereof were obtained in the same manner as in Example 1 except that 5-trifluoro-m-phenylenediamine was used instead of 5-nitro-m-phenylenediamine. The evaluation results of the obtained sample are shown in Table 1. Note that Polymer B has a structure of Chemical Formula (IX) in which Ar⁵ is Chemical Formula (X) and Ar⁶ is Chemical Formula (XIII).

### (Example 3)

An aromatic polyamide (Polymer C) and a film thereof were obtained in the same manner as in Example 1 except that 3,3'-sulfonylbisbenzoic acid dichloride was used instead of 2-nitroisophthalic acid dichloride. The evaluation results of the obtained sample are shown in Table 1. Note that Polymer C has a structure of Chemical Formula (IX) in which Ar⁵ is Chemical Formula (X) and Ar⁶ is Chemical Formula (XIV).

### (Example 4)

An aromatic polyamide (Polymer D) and a film thereof were obtained in the same manner as in Example 1 except that 4,4'-diaminodiphenyl sulfone was used instead of 5-nitro-m-phenylenediamine. The evaluation results of the obtained sample are shown in Table 1. Note that Polymer D has a structure of Chemical Formula (IX) in which Ar⁵ is Chemical Formula (X) and Ar⁶ is Chemical Formula (XI).

### (Example 5)

An aromatic polyamide (Polymer E) and a film thereof were obtained in the same manner as in Example 1 except that 2,7-naphthalenedicarbonyl dichloride was used instead of 2-nitroisophthalic acid dichloride. The evaluation results of the obtained sample are shown in Table 1. Note that Polymer E has a structure of Chemical Formula (III) in which Ar³ is Chemical Formula (IV) and Ar⁴ is Chemical Formula (V).

### (Example 6)

An aromatic polyamide (Polymer F) and a film thereof were obtained in the same manner as in Example 1 except that 1,6-naphthalenedicarbonyl dichloride was used instead of 2-nitroisophthalic acid dichloride. The evaluation results of the obtained sample are shown in Table 1. Note that Polymer F has a structure of Chemical Formula (III) in which Ar³ is Chemical Formula (IV) and Ar⁴ is Chemical Formula (VI).

### (Example 7)

After dissolving 2,5-thiophenedicarboxylic acid-1,1-dioxide in dehydrated chlorobenzene, oxalyl chloride corresponding to 2.2 molar equivalents relative to the dicarboxylic acid was added dropwise at room temperature. This solution was heated to 60°C and stirred for 2 hours, then returned to room temperature and distilled off under reduced pressure to remove the surplus oxalyl chloride. 2,5-thiophenedicarboxylic acid dichloride-1,1-dioxide was precipitated by adding heptane to the reaction solution. After filtering this powder, it was isolated by drying under reduced pressure. An aromatic polyamide (Polymer G) and a film thereof were obtained in the same manner as in Example 1 except that the 2,5-thiophenedicarboxylic acid dichloride-1,1-dioxide obtained by the above method was used instead of 2-nitroisophthalic acid dichloride. The evaluation results of the obtained sample are shown in Table 1. Note that Polymer G has neither structure of Chemical Formula (III) nor (IX).

### (Example 8)

An aromatic polyamide (Polymer H) and a film thereof were obtained in the same manner as in Example 1 except that instead of adding 5-nitro-m-phenylenediamine corresponding to 100 mol% relative to the total amount of diamine, 5-nitro-m-phenylenediamine corresponding to 80 mol% relative to the total amount of diamine and 2-chloro-p-phenylenediamine corresponding to 20 mol% were added. The evaluation results of the obtained sample are shown in Table 1. Note that Polymer H comprises a structure of Chemical Formula (IX) in which Ar⁵ is Chemical Formula (IX) and Ar⁶ is Chemical Formula (XIII).

### (Example 9)

An aromatic polyamide (Polymer I) and a film thereof were obtained in the same manner as in Example 1 except that instead of adding 2-nitroisophthalic acid dichloride corresponding to 99 mol% relative to the total amount of diamine, 2-nitroisophthalic acid dichloride corresponding to 80 mol% relative to the total amount of diamine and 2-chloroterephthalic acid dichloride corresponding to 19 mol% were added. The evaluation results of the obtained sample are shown in Table 1. Note that Polymer I comprises a structure of Chemical Formula (IX) in which Ar⁵ is Chemical Formula (X) and Ar⁶ is Chemical Formula (XIII).

### (Example 10)

An aromatic polyamide (Polymer A) and a film thereof were obtained in the same manner as in Example 1 except that instead of performing poling treatment, both ends of the dried film were supported and it was uniaxially stretched 1.1 times at 130°C using a stretching machine. The evaluation results of the obtained sample are shown in Table 1.

### (Comparative Example 1)

In dehydrated DMAc, 2,2'-ditrifluoromethyl-4,4'-diaminobiphenyl (TFMB) corresponding to 100 mol% relative to the total amount of diamine was dissolved as a diamine under a nitrogen stream, and the liquid temperature was cooled to 5°C in an ice water bath. Thereinto, while maintaining the inside of the system in the ice water bath under a nitrogen stream, 2-chloroterephthaloyl chloride (CTPC) corresponding to 99 mol% relative to the total amount of diamine was added over 30 minutes, and after the total amount was added, stirring was performed for about 1 hour to polymerize an aromatic polyamide (Polymer J). The obtained polymerization solution was added to a large amount of pure water while stirring to solidify Polymer J into a fiber shape, which was then pulverized with a mixer for 5 minutes and dried in a hot air oven at 80°C for 1 hour and in a vacuum oven at 120°C for 12 hours to obtain a powder of Polymer J. Thereafter, a film made of Polymer J was obtained in the same manner as in Example 1. The evaluation results of the obtained sample are shown in Table 1. Note that Polymer J has neither structure of Chemical Formula (III) nor (IX).

### (Comparative Example 2)

In dehydrated DMAc, 5-nitro-m-phenylenediamine corresponding to 100 mol% relative to the total amount of diamine was dissolved as a diamine under a nitrogen gas stream, and the liquid temperature was cooled to 5°C in an ice water bath. Thereinto, while maintaining the inside of the system in the ice water bath under a nitrogen gas stream, CTPC corresponding to 99 mol% relative to the total amount of diamine was added over 30 minutes, and after the total amount was added, stirring was performed for about 1 hour to polymerize an aromatic polyamide (Polymer K). The obtained polymerization solution was added to a large amount of pure water while stirring to solidify Polymer K into a fiber shape, which was then pulverized with a mixer for 5 minutes and dried in a hot air oven at 80°C for 1 hour and in a vacuum oven at 120°C for 12 hours to obtain a powder of Polymer K. A solution was obtained by dissolving Polymer K in DMAc so that the polymer concentration was 10% by mass. The solution of Polymer K was applied in a film shape onto a glass plate provided with an Al electrode, and after being dried in a hot air oven at 130°C for 10 minutes, poling treatment was performed under the above-mentioned conditions to obtain a film made of Polymer K having a thickness of 10 µm. The evaluation results of the obtained sample are shown in Table 1. Note that Polymer K has neither structure of Chemical Formula (III) nor (IX).

### (Comparative Example 3)

In dehydrated DMAc (boiling point 165°C), m-phenylenediamine corresponding to 100 mol% relative to the total amount of diamine was dissolved as a diamine under a nitrogen gas stream, and the liquid temperature was cooled to 5°C in an ice water bath. Thereinto, while maintaining the inside of the system in the ice water bath under a nitrogen gas stream, isophthalic acid dichloride corresponding to 99 mol% relative to the total amount of diamine was added over 30 minutes, and after the total amount was added, stirring was performed for about 1 hour to polymerize an aromatic polyamide (Polymer L). The obtained polymerization solution was added to a large amount of pure water while stirring to solidify Polymer L into a fiber shape, which was then pulverized with a mixer for 5 minutes and dried in a hot air oven at 80°C for 1 hour and in a vacuum oven at 120°C for 12 hours to obtain a powder of Polymer L. A solution was obtained by dissolving Polymer L in DMAc so that the polymer concentration was 10% by mass. The solution of Polymer L was applied in a film shape onto a glass plate provided with an Al electrode, and after being dried in a hot air oven at 130°C for 10 minutes, poling treatment was performed under the above-mentioned conditions to obtain a film made of Polymer L having a thickness of 10 µm. Here, as the hot air oven, a safety oven SPH100 (manufactured by ESPEC CORP.) was used, and it was used 1 hour after the temperature display reached the set temperature with the opening/closing damper at 50%. The evaluation results of the obtained sample are shown in Table 1. Note that Polymer L has a structure of Chemical Formula (III) in which both Ar³ and Ar⁴ are Chemical Formula (IV).

### (Comparative Example 4)

A film made of Polymer M was obtained in the same manner as in Example 1 except that Nylon 11 (Rilsan (R) PA11, Polymer M) was used instead of the aromatic polyamide. The evaluation results of the obtained sample are shown in Table 1. Note that Polymer M has neither structure of Chemical Formula (III) nor (IX).

### (Comparative Example 5)

Using a commercially available piezoelectric PVDF film (KF Piezo Film, manufactured by Kureha Corporation) as a sample, each evaluation was carried out. The evaluation results are shown in Table 1. Note that PVDF has neither structure of Chemical Formula (III) nor (IX). Normalized molecular orientation measurement was not performed.

### [Table 1]

**Table 1**

| | Polymer | Satisfaction of Structural Requirement | | | Remanent Polarization (mC/m²) | Glass Transition Temperature (°C) | Piezoelectric Constant (pm/V) | Change Rate of Piezoelectric Constant by Heat Treatment | Elastic Modulus (GPa) | MORc |
|---|---|---|---|---|---|---|---|---|---|---|
| | | (i) | (II) | any of (iii) to (vi) | | | | | | |
| Ex.1 | A | ○ | ○ | ○ | 37.4 | >250 | 36 | 0.13 | 5.1 | 1.2 |
| Ex.2 | B | ○ | ○ | ○ | 25.2 | >250 | 24 | 0.20 | 5.0 | 1.1 |
| Ex.3 | C | ○ | ○ | ○ | 28.3 | >250 | 22 | 0.35 | 4.8 | 1.0 |
| Ex.4 | D | ○ | ○ | ○ | 26.3 | >250 | 23 | 0.36 | 4.9 | 1.0 |
| Ex.5 | E | ○ | ○ | ○ | 22.8 | >250 | 20 | 0.30 | 4.7 | 1.0 |
| Ex.6 | F | ○ | ○ | ○ | 20.0 | >250 | 16 | 0.31 | 4.5 | 1.0 |
| Ex.7 | G | ○ | ○ | ○ | 19.6 | >250 | 15 | 0.48 | 5.0 | 1.0 |
| Ex.8 | H | ○ | ○ | ○ | 17.2 | >250 | 10 | 0.38 | 6.0 | 1.1 |
| Ex.9 | I | ○ | ○ | ○ | 16.1 | >250 | 8 | 0.42 | 6.2 | 1.1 |
| Ex.10 | A | ○ | ○ | ○ | 20.2 | >250 | 18 | 0.15 | 6.0 | 1.4 |
| C.Ex.1 | J | ○ | × | × | <DL | >250 | <DL | - | 8.6 | 1.0 |
| C.Ex.2 | K | ○ | × | ○ | <DL | >250 | <DL | - | 6.7 | 1.0 |
| C.Ex.3 | L | ○ | ○ | × | <DL | >250 | <DL | - | 5.2 | 1.0 |
| C.Ex.4 | M | × | ○ | × | 20.0 | 43 | 17 | 0.52 | 3.2 | 1.0 |
| C.Ex.5 | PVDF | × | ○ | × | 60.4 | <25 | 25 | 0.86 | 2.8 | - |

| | | | | | | | | | | |
|---|---|---|---|---|---|---|---|---|---|---|
| Ex.: Example; C.Ex.: Comparative Example; ○: satisfy; ×: not satisfy; <DL: less than detection limit | | | | | | | | | | |

## Claims

1. A polymer comprising a structure of the following Chemical Formula (I) as a repeating unit, the polymer satisfying the following (i) and (ii):
(i): a hydrogen-bonding group A in the Chemical Formula (I) is bonded to a ring atom; and
(ii): in pathways connecting atoms between two "A"s in the Chemical Formula (I), the number of atoms present on the shortest pathway is an odd number;
Chemical Formula (I): 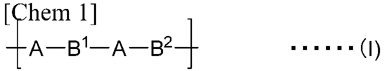 wherein A is a hydrogen-bonding group, and B¹ and B² are n-membered ring groups (where n is a natural number of 5 or more and 10 or less).

2. The polymer according to claim 1, wherein the polymer has a remanent polarization of 15 mC/m² or more and 300 mC/m² or less.

3. The polymer according to claim 1, wherein the hydrogen-bonding group A is at least one of an amide group, a urea group, and a urethane group.

4. The polymer according to claim 1, which is an aromatic polyamide wherein the hydrogen-bonding group A is an amide group, and B¹ and B² are both aromatic groups.

5. The aromatic polyamide according to claim 4, wherein a structure in the repeating unit satisfies at least one of the following (v) to (viii):
(v): an electron-donating group is bonded to an atom on the shortest pathway among pathways along bonds connecting two amide group N atoms;
(vi): an electron-withdrawing group is bonded to an atom on the shortest pathway among pathways along bonds connecting two amide group C atoms;
(vii): an electron-withdrawing group is bonded to an atom that is not on the shortest pathway among pathways along bonds connecting two amide group N atoms; and
(viii): an electron-donating group is bonded to an atom that is not on the shortest pathway among pathways along bonds connecting two amide group C atoms.

6. The aromatic polyamide according to claim 5, having a molecular skeleton structure of the following Chemical Formula (III): 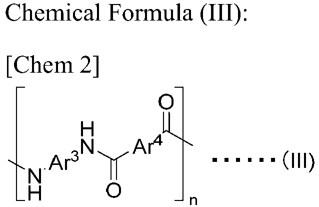
wherein Ar³ and Ar⁴ are groups containing a molecular skeleton structure shown in Chemical Formulas (IV) to (VIII); 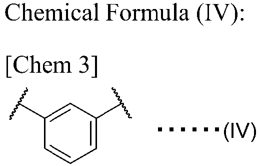 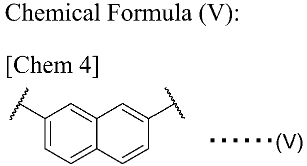 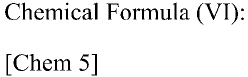 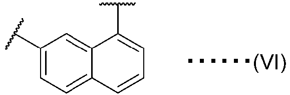 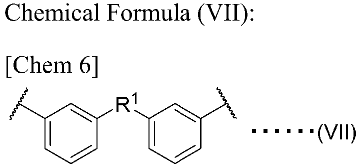
wherein R¹ is an arbitrary group satisfying (v) to (viii) in claim 5; 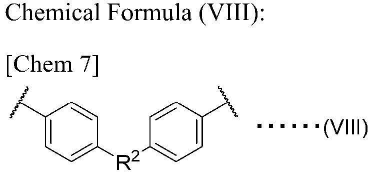
wherein R² is an arbitrary group satisfying (v) to (viii) in claim 5.

7. The aromatic polyamide according to claim 5, having a structure of the following Chemical Formula (IX):
Chemical Formula (IX): 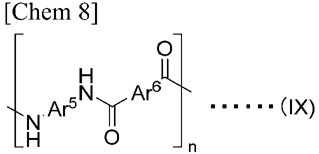
wherein Ar⁵ is a group containing a structure of Chemical Formulas (X) to (XII), and
Ar⁶ is a group containing a structure of Chemical Formulas (XIII) to (XV);
Chemical Formula (X): 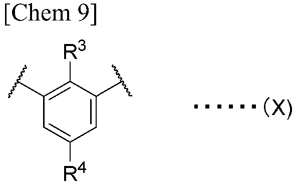
wherein R³ is -H or an electron-donating group, and R⁴ is an electron-withdrawing group; 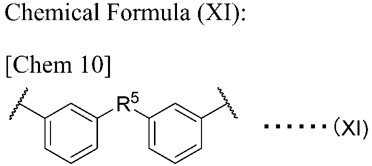
wherein R⁵ is an electron-donating group; 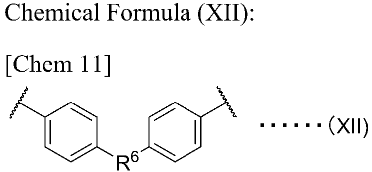
wherein R⁶ is an electron-withdrawing group; 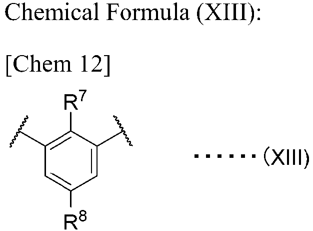
wherein R⁷ is an electron-withdrawing group, and R⁸ is -H or an electron-donating group; 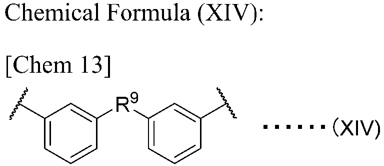
wherein R⁹ is an electron-withdrawing group; 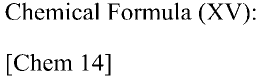 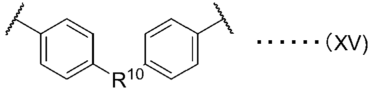
wherein R¹⁰ is an electron-donating group.

8. The aromatic polyamide according to claim 7, comprising at least one group of a perfluoroalkyl group having 1 or more and 3 or less carbon atoms, a nitro group, a cyano group, and a sulfone group.

9. The aromatic polyamide according to claim 4, having a glass transition temperature of 130°C or higher and 400°C or lower.

10. A molded body comprising the aromatic polyamide according to claim 4 as a main component.

11. The molded body according to claim 10, wherein at least one of a piezoelectric constant d₃₁ and d₃₃ is greater than 0 pC/N and 50.0 pC/N or less.

12. A film comprising the aromatic polyamide according to claim 4 as a main component.

13. The film according to claim 12, which has an elastic modulus obtained by AFM of 4.0 GPa or more and 15.0 GPa or less.

14. The film according to claim 12, having a normalized molecular orientation MORc of 1.1 or more and 15 or less.

15. The molded body according to claim 10, wherein, when a dielectric constant after a heat treatment at 150°C for 10 minutes is d', a larger value of absolute values |(d₃₁ - d'₃₁) / d₃₁ | and |(d₃₃ - d'₃₃) / d₃₃ |of a change in piezoelectric constant by the heat treatment is 0 or more and 0.5 or less.

16. A piezoelectric element comprising the molded body according to claim 10 and/or the film according to claim 12.

17. An actuator comprising the molded body according to claim 10 and/or the film according to claim 12.

18. A vibrator comprising the molded body according to claim 10 and/or the film according to claim 12.

19. A vibration sensor comprising the piezoelectric element according to claim 16.

20. A speaker equipped with the actuator according to claim 17.

21. A structural health monitoring system comprising at least the vibration sensor according to claim 19 and a communication device, the structural health monitoring system diagnosing a structure by detecting a vibration state of the structure using the vibration sensor.
